# EUROPÄISCHE PATENTSCHRIFT

(11) **EP 3 721 687 B1**
(45) Veröffentlichungstag und Bekanntmachung des Hinweises auf die Patenterteilung: **15.02.2023**
(21) Anmeldenummer: 18808394.3
(22) Anmeldetag: 04.12.2018
(51) Int. Cl.: H05K 7/14, G06F 1/16

(54) **BAUKASTENSYSTEM ZUM HERSTELLEN EINES ELEKTRONIKGERÄTS**
MODULAR SYSTEM FOR PRODUCING AN ELECTRONIC DEVICE
SYSTÈME MODULAIRE POUR RÉALISER UN APPAREIL ÉLECTRONIQUE

(30) Priorität: 08.12.2017 BE 201705919; 08.12.2017 DE 102017129251
(43) Veröffentlichungstag der Anmeldung: 14.10.2020
(73) Patentinhaber: PHOENIX CONTACT GmbH & Co. KG, 32825 Blomberg (DE)
(72) Erfinder: BEST, Frank, 31675 Bückeburg (DE); SCHULZE, Volker, 32825 Blomberg (DE); EUSTERHOLZ, Helmut, 33102 Paderborn (DE)
(86) Internationale Anmeldenummer: PCT/EP2018/083525
(87) Internationale Veröffentlichungsnummer: WO 2019/110604

(56) Entgegenhaltungen:
- EP-A1- 2 399 435
- DE-C1- 4 428 687
- DE-C1- 4 428 687
- DE-U1- 8 805 257
- DE-U1- 9 408 294
- US-A1- 2017 257 959

## Beschreibung

Die Erfindung betrifft ein Baukastensystem zum Herstellen eines Elektronikgeräts nach dem Oberbegriff des Anspruchs 1 sowie ein Verfahren zum Herstellen eines Elektronikgeräts unter Verwendung eines Baukastensystems.

Ein derartiges Baukastensystem zum Herstellen eines Elektronikgeräts umfasst ein Gehäuse, das einen Aufnahmeraum ausbildet, und eine Leiterplatte, die entlang einer Einschubrichtung in den Aufnahmeraum des Gehäuses einsetzbar und in einer Montagestellung in dem Aufnahmeraum aufgenommen ist.

Ein derartiges Elektronikgerät kann beispielsweise zusammen mit anderen Elektronikgeräten entlang einer Anreihrichtung kombiniert werden, sodass eine Mehrzahl von Elektronikgeräten entlang der Anreihrichtung aneinander angereiht sind. Das Elektronikgerät kann beispielsweise zusammen mit den anderen Elektronikgeräten an einer Tragschiene aufgenommen werden, sodass auf diese Weise eine elektrische Baugruppe geschaffen wird, die beispielsweise Steuer- oder Auswertefunktionen im Rahmen einer industriellen Anlage übernehmen kann.

Elektronische Bauteile sind hierbei auf der Leiterplatte angeordnet, die in das Gehäuse eingesetzt werden kann, um das Elektronikgerät auszubilden. Die Leiterplatte erstreckt sich in der Montagestellung zum Beispiel parallel zu Seitenwandungen des Gehäuses, zwischen denen der Aufnahmeraum gebildet ist, und ist in dem Gehäuse in geschützter Weise eingefasst.

Wünschenswert ist eine Elektronikgerät, dass einfach, insbesondere zum Einsetzen und Fixieren der Leiterplatte in dem Gehäuse, montiert werden kann, dabei aber variabel auch in Abhängigkeit von der Ausgestaltung von elektronischen Bauteilen der Leiterplatte zum Beispiel mit Anschlüssen oder anderen Funktionskomponenten bestückbar ist.

Elektronikgeräte der betreffenden Art sind beispielsweise bekannt aus DE 44 28 687 C1, EP 2 399 435 A1, US 2017/257959 A1 wie auch DE 94 08 294 U1. Bei einem aus der DE 44 28 687 C1 bekannten Elektronikgerät kann eine Leiterplatte zusammen mit einem an Bedienelementen der Leiterplatte vormontierten Gehäuseteil in ein Gehäuse eingesetzt werden. In montierter Stellung verschließt das Gehäuseteil eine Öffnung des Gehäuses.

Bei einem aus der EP 2 399 435 B1 bekannten Elektronikgerät werden Gehäuse mit Anschlusskammern an einer Leiterplatte vormontiert. Die Leiterplatte kann sodann zusammen mit Seitenteilen an einem Gehäusesockel angeordnet werden, um das Elektronikgerät zu komplettieren.

Des Weiteren ist ein Baukastensystem zum Herstellen eines Elektronikgeräts, der betreffenden Art bekannt aus DE 88 05 257 U1, bei dem ein Gehäuse einen Aufnahmeraum ausbildet und eine Leiterplatte entlang einer Einschubrichtung in den Aufnahmeraum des Gehäuses einsetzbar und in einer Montagestellung in dem Aufnahmeraum aufgenommen ist. Dabei weist ein mit der Leiterplatte verbindbares Ansetzteil eine erste Führungseinrichtung zur Führung an einer zweiten Führungseinrichtung des Gehäuses auf und ist mit der Leiterplatte derart verbindbar, dass bei Einsetzen der Leiterplatte in den Aufnahmeraum das Ansetzteil über die ersten Führungseinrichtungen an der zweiten Führungseinrichtung des Gehäuses entlang der Einschubrichtung verschiebbar geführt ist.

Aufgabe der vorliegenden Erfindung ist es, ein Baukastensystem sowie ein Verfahren zum Herstellen eines in Abhängigkeit von der Anwendung konfigurierbaren Elektronikgeräts unter Verwendung eines Baukastensystems bereitzustellen, die eine einfache und somit kostengünstige Montage des Elektronikgeräts bei variabler Bestückbarkeit insbesondere mit elektrischen und/oder mechanischen Anschlüssen ermöglichen.

Diese Aufgabe wird durch einen Gegenstand mit den Merkmalen des Anspruchs 1 gelöst.

Demnach weist das Baukastensystem eine Mehrzahl von mit der Leiterplatte verbindbaren Ansetzteilen auf, die jeweils, betrachtet entlang der Einschubrichtung, eine Teilung aufweisen, die einer vorbestimmten kleinsten Teilungseinheit oder einem ganzzahligen Vielfachen der vorbestimmten kleinsten Teilungseinheit entspricht, wobei jedes Ansetzteil eine erste Führungseinrichtung zur Führung an einer zweiten Führungseinrichtung des Gehäuses aufweist und eine Kombination unterschiedlicher Ansetzteile entlang der Einschubrichtung aneinander angereiht mit der Leiterplatte derart verbindbar ist, dass bei Einsetzen der Leiterplatte in den Aufnahmeraum die Kombination von Ansetzteilen über ihre ersten Führungseinrichtungen an der zweiten Führungseinrichtung des Gehäuses entlang der Einschubrichtung verschiebbar geführt ist.

Im Rahmen des Baukastensystems sind somit mehrere unterschiedliche Ansetzteile vorhanden, die variabel und in unterschiedlicher Weise miteinander kombiniert werden können und erfindungsgemäß Blendenteile für einen mit der Leiterplatte elektrisch verbundenen elektrischen Anschluss ,Klemmeneinrichtungen mit zumindest einer Stecköffnung zum Anschließen eines elektrischen Leiters, geschlossene, flächige Wandungselemente zum Verschließen des Gehäuses, Gitterelemente oder mechanische und/oder elektrische Funktionselemente ausbilden.

Dadurch, dass die Ansetzteile eine Teilung aufweisen, die einer vorbestimmten kleinsten Teilungseinheit oder einem ganzzahligen Vielfachen der vorbestimmten kleinsten Teilungseinheit entspricht, können grundsätzlich beliebige Kombinationen von Ansetzteilen derart entlang der Einschubrichtung aneinander angereiht werden, dass sich eine Kombination von Ansetzteilen mit einer vorbestimmten Gesamtlänge ergibt, entsprechend zum Beispiel der Länge einer Gehäuseöffnung (gemessen entlang der Einschubrichtung), die durch die Ansetzteile zu verschließen ist. Eine Leiterplatte kann somit mit ganz unterschiedlichen Kombinationen von Ansetzteilen bestückt werden, um zusammen mit den Ansetzteilen in den Aufnahmeraum des Gehäuses eingesetzt zu werden und somit das Elektronikgerät auszubilden.

Durch die Verwendung unterschiedlicher Ansetzteile in Kombination miteinander können unterschiedliche Funktionen an der Leiterplatte bereitgestellt werden, wie dies nachstehend noch erläutert werden soll. Es ergibt sich somit ein flexibel verwendbares Baukastensystem, mittels dessen ganz unterschiedliche Elektronikgeräte in variabler Weise hergestellt und anwendungsbezogen konfiguriert werden können. Die Ansetzteile können hierbei insbesondere eine Geräteschnittstelle von der Leiterplattenbaustufe des hergestellten Elektronikgeräts nach Außen bereitstellen.

Die vorbestimmte kleinste Teilungseinheit (kurz: TE; englisch: Unit) definiert eine Grundlänge entlang der Einschubrichtung. Einige Ansetzteile können beispielsweise eine Teilung entsprechend der einfachen Teilungseinheit aufweisen. Andere Ansetzteile können eine Teilung entsprechend der doppelten Teilungseinheit aufweisen, also doppelt so lang wie die Teilungseinheit sein. Wiederum andere Ansetzteile können beispielsweise eine Teilung entsprechend dem Dreifachen der Teilungseinheit aufweisen. Unterschiedliche Ansetzteile können somit entlang der Einschubrichtung miteinander kombiniert werden, um eine Kombination von Ansetzteilen mit einer vorbestimmten Länge zu schaffen. Weist beispielsweise eine Gehäuseöffnung, in die die Kombination von Ansetzteilen einzuschieben ist, eine Länge entsprechend der fünffachen Teilungseinheit auf, so können Ansetzteile derart miteinander kombiniert werden, dass sich die Gesamtlänge entsprechend der fünffachen Teilungseinheit ergibt.

Ein jedes Ansetzteil weist hierbei (zumindest) eine erste Führungseinrichtung auf, über die die Ansetzteile an einer zugeordneten zweiten Führungseinrichtung des Gehäuses geführt werden, wenn die Leiterplatte zusammen mit der daran angeordneten Kombination von Ansetzteilen in den Aufnahmeraum des Gehäuses eingesetzt wird. Das Einsetzen der Leiterplatte in den Aufnahmeraum des Gehäuses erfolgt somit in einer über die Ansetzteile geführten Weise. In der Montagestellung wird die Leiterplatte dann vorzugsweise über die Ansetzteile in Position in dem Aufnahmeraum gehalten.

In einer Ausgestaltung weist das Gehäuse zwei entlang einer Anreihrichtung zueinander beabstandete, zwischen sich einen Aufnahmeraum ausbildende Seitenwandungen auf. Die Einschubrichtung ist quer zur Anreihrichtung gerichtet. In der Montagestellung ist die Leiterplatte senkrecht zur Anreihrichtung erstreckt und somit parallel zu den Seitenwandungen ausgerichtet und in dieser Weise in dem Aufnahmeraum zwischen den Seitenwandungen aufgenommen.

Mehrere Ansetzteilen können miteinander kombiniert und zur Herstellung des Elektronikgeräts an der Leiterplatte vormontiert werden, um die Leiterplatte zusammen mit den daran angeordneten Ansetzteilen in das Gehäuse einzusetzen. In der Vormontagestellung sind die Ansetzteile stoffschlüssig (zum Beispiel mittels Löten), kraftschlüssig oder formschlüssig mit der Leiterplatte verbunden und bilden somit zusammen mit der Leiterplatte eine vormontierte Baueinheit, die an das Gehäuse des Elektronikgeräts angesetzt werden kann.

Das Ansetzen dieser vormontierten Baueinheit erfolgt in geführter Weise dadurch, dass erste Führungseinrichtungen der Ansetzteile mit zweiten Führungseinrichtungen zum Beispiel an den Seitenwandungen des Gehäuses in Eingriff gebracht werden, sodass die Baueinheit, also die Ansetzteile zusammen mit der Leiterplatte, in das Gehäuse eingeschoben werden kann und die Leiterplatte in eine definierte Lage innerhalb des Aufnahmeraums gelangt. Jedes Ansetzteil kann hierbei zwei parallel zueinander, entlang der Einschubrichtung erstreckte, erste Führungseinrichtungen aufweisen, während die Seitenwandungen jeweils eine entlang der Einschubrichtung erstreckte, zweite Führungseinrichtung aufweisen.

In der Montagestellung fixieren die Ansetzteile die Leiterplatte dann in dem Aufnahmeraum, indem die Leiterplatte über die Ansetzteile mit den Seitenwandungen verbunden ist. Die Ansetzteile erstrecken sich hierbei zwischen den Seitenwandungen und verbinden die Seitenwandungen formschlüssig miteinander, sodass das Gehäuse komplettiert ist und die Ansetzteile beispielsweise das Gehäuse nach außen hin abschließen.

An die Leiterplatte können ganz beliebige Ansetzteile zur Bereitstellung ganz unterschiedlicher Funktionen angesetzt werden. Die Leiterplatte kann somit, abhängig von einer gewünschten Ausgestaltung und Funktion der durch die Leiterplatte bereitgestellten elektronischen Baugruppe, mit unterschiedlichen Ansetzteilen bestückt werden, um die auf diese Weise geschaffene vormontierte Baueinheit in das Gehäuse einzusetzen und dadurch das Elektronikgerät zu montieren.

Zur Montage können die ersten Führungseinrichtungen der an der Leiterplatte angeordneten Kombination von Ansetzteilen und die zweiten Führungseinrichtungen der Seitenwandungen des Gehäuses vorzugsweise derart miteinander in Eingriff gebracht werden, dass die Ansetzteile in einer senkrecht zur Einschubrichtung erstreckten Ebene fest mit den Seitenwandungen verbunden sind, entlang der Einschubrichtung aber zu den Seitenwandungen verschiebbar sind, bis die Montagestellung erreicht ist und die Leiterplatte zum Beispiel zusätzlich in der erreichten Endposition im Gehäuse verrastet. Die Ansetzteile sind somit in der senkrecht zu Einschubrichtung erstreckten Ebene zu den Seitenwandungen festgelegt, also so mit den Seitenwandungen verbunden, dass eine feste Verbindung zwischen den Ansetzteilen und den Seitenwandungen besteht, die Ansetzteile jedoch entlang der Einschubrichtung zu den Seitenwandungen verschiebbar sind, bis die Montagestellung erreicht ist. Durch den Eingriff der ersten Führungseinrichtungen mit den zweiten Führungseinrichtungen wird somit eine Führung für die an der Leiterplatte angeordnete Kombination von Ansetzteilen an den Seitenwandungen geschaffen, aufgrund derer die Ansetzteile und darüber die Leiterplatte in definierter Weise zu den Seitenwandungen verschiebbar sind, ohne dass sich die Ansetzteile dabei ohne weiteres aus ihrem geführten Eingriff mit den Seitenwandungen lösen können.

Die Führung der Kombination von Ansetzteilen an den Seitenwandungen kann beispielsweise dadurch bereitgestellt werden, dass jede erste Führungseinrichtung formschlüssig mit einer zugeordneten zweiten Führungseinrichtung in Eingriff bringbar ist, indem ein Eingriff eines Stegs in eine Nut hergestellt wird im Sinne einer Nut-und-Feder-Verbindung. Eine der Führungseinrichtungen weist somit einen Steg auf, die in eine zugeordnete Nut der anderen Führungseinrichtung eingreift und dadurch eine Führung entlang der Einschubrichtung bereitstellt, gleichzeitig aber die Ansetzteile in der Ebene senkrecht zur Einschubrichtung so miteinander verbindet, dass der Eingriff zwischen den Ansetzteilen und den Seitenwandungen nicht ohne weiteres lösbar ist.

In einer konkreten Ausgestaltung weisen die zweiten Führungseinrichtungen der Seitenwandungen jeweils einen Steg auf, während die ersten Führungseinrichtungen eines jeden Ansetzteils jeweils eine mit dem Steg in Eingriff bringbare Nut aufweisen. Ein jedes Ansetzteil weist somit zwei Nuten auf, die mit jeweils einem Steg einer Seitenwandung in Eingriff gebracht werden können, sodass darüber das Ansetzteil an beiden Seitenwandungen verschiebbar geführt ist, dabei aber eine nicht ohne weiteres lösbare Verbindung zwischen dem Ansetzteil und den Seitenwandungen geschaffen wird, sodass das Ansetzteil in einer senkrecht zur Einschubrichtung erstreckten Ebene zu den Seitenwandungen formschlüssig festgelegt ist.

In alternativer Ausgestaltung ist auch denkbar, dass die ersten Führungseinrichtungen der Ansetzteile jeweils einen Steg und die zweiten Führungseinrichtungen der Seitenwandungen jeweils eine Nut, mit der ein Steg einer zugeordneten ersten Führungseinrichtung in Eingriff bringbar ist, aufweisen.

In anderer Ausgestaltung ist auch denkbar, dass das Führungssystem als ganze oder halbe Schwalbenschwanzführung mit schräggestelltem Nut-Steg-System ausgeführt ist.

Der Formschluss zwischen den Führungseinrichtungen ist insbesondere derart, dass die Ansetzteile in einer senkrecht zur Einschubrichtung erstreckten Ebene zu den Seitenwandungen festgelegt sind und somit eine Verbindung zwischen den Ansetzteilen und den Seitenwandungen geschaffen ist. Um hierbei zu verhindern, dass ein Ansetzteil entlang einer Querrichtung, die quer zur Anreihrichtung und quer zur Einschubrichtung erstreckt ist, außer Eingriff von einem zugeordneten Steg gelangen kann, kann im Bereich der Nut ein Blockiersteg angeordnet sein, der den Steg in der Nut blockiert und ein Herausrutschen des Stegs aus der Nut entlang der Querrichtung verhindert. Der Steg kann beispielsweise in eine entlang der Querrichtung weisende Eingriffsrichtung in die Nut eingreifen. Der Blockiersteg blockiert ein Herausgleiten des Stegs entgegen der Eingriffsrichtung aus der Nut und sichert somit den Eingriff des Stegs in die Nut.

Um die Ansetzteile in einer senkrecht zur Einschubrichtung erstreckten Ebene fest (aber entlang der Einschubrichtung aber zu den Seitenwandungen bis in die Montagestellung verschiebbar) mit den Seitenwandungen zu verbinden, umgreift die Nut den Führungssteg vorzugsweise an vier Seiten. Stufen, die der Führungssteg mit der zugeordneten Seitenwandung bildet, sind hierbei in Anlage mit dem Blockiersteg und einem Begrenzungsabschnitt der Nut. Der Führungssteg wird somit formschlüssig in Eingriff mit der Nut gehalten und kann in einer Ebene senkrecht zur Einschubrichtung nicht aus der Nut herausbewegt werden.

In einer Ausgestaltung sind die Ansetzteile in der Montagestellung entlang der Anreihrichtung zwischen den Seitenwandungen erstreckt. Die Ansetzteile der an die Leiterplatte angesetzten Kombination von Ansetzteilen können sich beispielsweise flächig entlang der Anreihrichtung und der Einschubrichtung erstrecken und können beispielsweise eine Begrenzung des Aufnahmeraums nach außen hin bereitstellen, sodass die Ansetzteile das Gehäuse komplettieren und zusammen mit anderen Gehäuseabschnitten den Aufnahmeraum des Gehäuses nach außen hin abschließen.

Die Ansetzteile können beispielsweise, betrachtet in einer durch die Anreihrichtung und die Einschubrichtung aufgespannten Ebene, jeweils einen Körper aufweisen, der ein Flächenelement bereitstellt, das betrachtet entlang der Einschubrichtung die Teilung des jeweiligen Ansetzteils definiert. Der Körper kann beispielsweise eine rechteckige Grundform (in einer durch die Anreihrichtung und die Einschubrichtung aufgespannten Ebene) aufweisen, mit einer Teilung, die der Teilungseinheit oder einem ganzzahligen Vielfachen der Teilungseinheit entspricht. Mehrere Ansetzteile können entlang der Einschubrichtung aneinander angereiht und aneinander anschließend an der Leiterplatte angeordnet werden, sodass die Leiterplatte in modularer Weise mit unterschiedlichen Kombinationen von Ansetzteilen bestückt werden kann.

In einer Ausgestaltung weist die Leiterplatte entlang der Einschubrichtung erstreckte, einander gegenüberliegende Seitenkanten auf, an denen die Ansetzteile anzuordnen sind. Eine gewünschte Kombination von Ansetzteilen wird somit an den Seitenkanten der Leiterplatte aneinander angereiht und miteinander kombiniert, sodass die Ansetzteile in einem mit der Leiterplatte verbundenen Zustand sich entlang der Seitenkanten der Leiterplatte erstrecken.

Die Ansetzteile sind hierbei derart an der Leiterplatte anzuordnen, dass sie entlang der Anreihrichtung von der Leiterplatte vorstehen. Während die Leiterplatte sich entlang einer durch die Einschubrichtung und die Querrichtung aufgespannten Ebene flächig erstreckt, sind die Ansetzteile an den entlang der Einschubrichtung erstreckten Seitenkanten der Leiterplatte angeordnet und stehen senkrecht zur Ebene der flächig erstreckten Leiterplatte, also entlang der Anreihrichtung, gegenüber der Leiterplatte.

Zur Montage der Leiterplatte in dem Gehäuse wird die Leiterplatte mit einer Kombination von Ansetzteilen bestückt und zusammen mit den Ansetzteilen in das Gehäuse eingesetzt. Hierbei kann vorzugsweise vorgesehen sein, dass die Leiterplatte in der Montagestellung (ausschließlich) über die Ansetzteile in dem Aufnahmeraum des Gehäuses fixiert ist, sodass eine Verbindung zwischen der Leiterplatte und dem Gehäuse (nur) mittelbar über die Ansetzteile geschaffen wird. Die Leiterplatte wird somit über die Ansetzteile in dem Aufnahmeraum des Gehäuses festgelegt.

In einer Ausgestaltung können die Ansetzteile formschlüssig oder kraftschlüssig oder auch stoffschlüssig mit der Leiterplatte zu verbinden sein. Hierzu können die Ansetzteile beispielsweise auf die Leiterplatte aufgesteckt werden, sodass eine stoffschlüssige (zum Beispiel durch Löten), kraftschlüssige oder formschlüssige(beispielsweise rastende) Verbindung zwischen den Ansetzteilen und der Leiterplatte hergestellt wird.

Beispielsweise können hierzu einige Ansetzteile einen Rasthaken aufweisen, der dazu ausgebildet ist, in eine zugeordnete Rastöffnung der Leiterplatte einzugreifen, um darüber das Ansetzteil an der Leiterplatte festzulegen. Beispielsweise kann zur Verbindung mit der Leiterplatte das Ansetzteil auf eine Seitenkante der Leiterplatte aufzustecken sein, wodurch der Rasthaken rastend in Eingriff mit der zugeordneten Rastöffnung der Leiterplatte schnappt.

Die Ansetzteile können ganz unterschiedliche Funktionen übernehmen und hierzu ganz unterschiedlich ausgestaltet sein.

So kann ein Ansetzteil beispielsweise ein Blendenteil für einen mit der Leiterplatte (elektrisch) verbundenen elektrischen Anschluss bereitstellen. Hierzu kann das Ansetzteil beispielsweise eine Öffnung aufweisen über die ein Steckverbinderteil mit dem elektrischen Anschluss verbunden werden kann.

In anderer Ausgestaltung kann das Ansetzteil beispielsweise eine Klemmeneinrichtung verwirklichen, die ein oder mehrere Stecköffnungen aufweist, in die elektrische Leiter (zum Beispiel mit abisolierten Leitungsenden) oder optische Leiter (Lichtwellenleiter) zum Zwecke der elektrischen oder optischen Kontaktierung eingesteckt werden können. Eine solche Klemmeneinrichtung kann beispielsweise als Federkraftklemme oder dergleichen verwirklicht sein. Unterschiedliche Klemmeneinrichtungen können hierbei Stecköffnungen zum Einstecken unterschiedlicher elektrischer Leiter mit unterschiedlichem Leitungsquerschnitt aufweisen. Klemmeneinrichtungen verschiedener Poldichte (also einer der Anschlusszahl entsprechenden Polzahl pro Teilungseinheit) zum Anschließen unterschiedlicher Leiter können somit miteinander kombiniert und an der Leiterplatte angeordnet werden.

Denkbar und möglich ist aber auch, dass ein Ansetzteil ein flächiges Wandungselement (ohne weitere elektrische Funktion) zum Verschließen des Gehäuses nach außen verwirklicht. Ein solches flächiges Wandungselement kann beispielsweise einen Abschluss das Gehäuse bereitstellen. Ein solches flächiges Wandungselement kann dabei auch als sogenannter Spacer dienen, um eine räumliche Separierung zwischen elektrischen Bauelementen, zum Beispiel zwischen elektrischen Anschlüssen, bereitzustellen und eine elektrische Wechselwirkung zwischen den elektrischen Bauelementen zu verhindern (im Sinne einer Vergrößerung einer Kriechstrecke).

In wiederum anderer Ausgestaltung kann das Ansetzteil auch ein Gitterelement bereitstellen, über das zum Beispiel eine Kühlung für eine in dem Aufnahmeraum eingefasste elektronische Baugruppe bereitgestellt werden kann.

Die Ansetzteile können auch Bedienelemente wie zum Beispiel Schalter (zum Beispiel DIP-Schalter), Regler (zum Beispiel für ein Potentiometer), Anzeigen zum Beispiel in Form von Leuchtdioden oder Displays, eine elektrische Sicherung oder auch mechanische oder elektrische Funktionselemente zum Beispiel in Form eines Schraubanschluss zur Befestigung des Gehäuses an einer anderen Baugruppe, zum Beispiel innerhalb eines Schaltschranks, oder auch in Form einer Schirmungsauflage zum Herstellen einer elektromagnetischen Schirmung oder einer Zugentlastung für ein daran festzulegendes Kabel bereitstellen.

Unterschiedliche Ansetzteile können hierbei eine unterschiedliche Farbgebung aufweisen, welche eine elektrotechnische Funktion signalisieren (wie z.B. L/N/PE, EXi, +/-, Signalart, Safety oder dergleichen, die üblicherweise durch eine spezifische Farbkennzeichnung angezeigt werden). Dies hat den technischen Vorteil, dass eine nachträgliche lokale Bedruckung des Gehäuses, wie bei herkömmlichen Elektronikgeräten, entfallen kann. Soll ein Gehäuse eines Elektronikgeräts abschnittsweise eine bestimmte Farbgebung oder Markierung aufweisen, so kann ein entsprechendes Ansetzteil verwendet und an das Gehäuse angesetzt werden, um somit eine gewünschte Farbgebung oder Markierung bereitzustellen.

Das Elektronikgerät kann vorzugsweise mit anderen Elektronikgeräten kombiniert werden, indem die Elektronikgeräte entlang der Anreihrichtung aneinander angereiht und zum Beispiel an einer Tragschiene befestigt werden. Das Elektronikgerät kann hierzu eine Befestigungseinrichtung, zum Beispiel in Form einer Rasteinrichtung, aufweisen, über die das Elektronikgerät an der Tragschiene festgelegt werden kann.

Die Aufgabe wird auch gelöst durch ein Verfahren zum Herstellen eines Elektronikgeräts unter Verwendung eines Baukastensystems, bei dem eine Leiterplatte entlang einer Einschubrichtung in einen Aufnahmeraum eines Gehäuses eingesetzt wird und in einer Montagestellung in dem Aufnahmeraum aufgenommen ist. Hierbei wird eine Kombination unterschiedlicher Ansetzteile, die erfindungsgemäß Blendenteile für einen mit der Leiterplatte elektrisch verbundenen elektrischen Anschluss ,Klemmeneinrichtungen mit zumindest einer Stecköffnung zum Anschließen eines elektrischen Leiters, geschlossene, flächige Wandungselemente zum Verschließen des Gehäuses, Gitterelemente oder mechanische und/oder elektrische Funktionselemente ausbilden und die jeweils, betrachtet entlang der Einschubrichtung, eine Teilung aufweisen, die einer vorbestimmten kleinsten Teilungseinheit oder einem ganzzahligen Vielfachen der vorbestimmten kleinsten Teilungseinheit entspricht, entlang der Einschubrichtung aneinander angereiht mit der Leiterplatte verbunden, und die Leiterplatte wird derart in den Aufnahmeraum des Gehäuses derart eingesetzt, dass erste Führungseinrichtungen der Kombination von Ansetzteilen an einer zweiten Führungseinrichtung des Gehäuses der Einschubrichtung verschiebbar geführt werden.

Die vorangehend für das Elektronikgerät beschriebenen Vorteile und vorteilhaften Ausgestaltungen finden analog auch auf das Verfahren Anwendung, sodass diesbezüglich auf das vorangehend Ausgeführte verwiesen werden soll.

Der der Erfindung zugrunde liegende Gedanke soll nachfolgend anhand der in den Figuren dargestellten Ausführungsbeispiele näher erläutert werden. Es zeigen:
- Fig. 1: eine perspektivische Ansicht eines Ausführungsbeispiels eines Elektronikgeräts;
- Fig. 2: eine andere perspektivische Ansicht des Elektronikgeräts;
- Fig. 3: eine Ansicht des Elektronikgeräts bei der Montage;
- Fig. 4: eine ausschnittsweise vergrößerte Ansicht im Ausschnitt A gemäß Fig. 3;
- Fig. 5: eine Ansicht des Elektronikgeräts bei der Montage;
- Fig. 6: eine andere Ansicht des Elektronikgeräts bei der Montage;
- Fig. 7: eine Ansicht des Elektronikgeräts bei der weiteren Montage;
- Fig. 8: eine Ansicht des Elektronikgeräts vor der Komplettierung durch einen Gehäusedeckel;
- Fig. 9: eine Ansicht von unterschiedlichen Ausführungsbeispielen von Ansetzteilen eines Baukastensystems;
- Fig. 10: eine Ansicht einer Leiterplatte zusammen mit daran angeordneten Ansetzteilen;
- Fig. 11: eine Ansicht einer Leiterplatte bei einem Ansetzen eines Ansetzteils an die Leiterplatte;
- Fig. 12: eine Ansicht der Leiterplatte mit angesetztem Ansetzteil;
- Fig. 13: eine Schnittansicht der Leiterplatte beim Ansetzen des Ansetzteils;
- Fig. 14: die Schnittansicht gemäß Fig. 13, mit angesetztem Ansetzteil; und
- Fig. 15: eine perspektivische, teilweise geschnittene Ansicht der Leiterplatte, mit angesetztem Ansetzteil entsprechend der Ansicht gemäß Fig. 14.

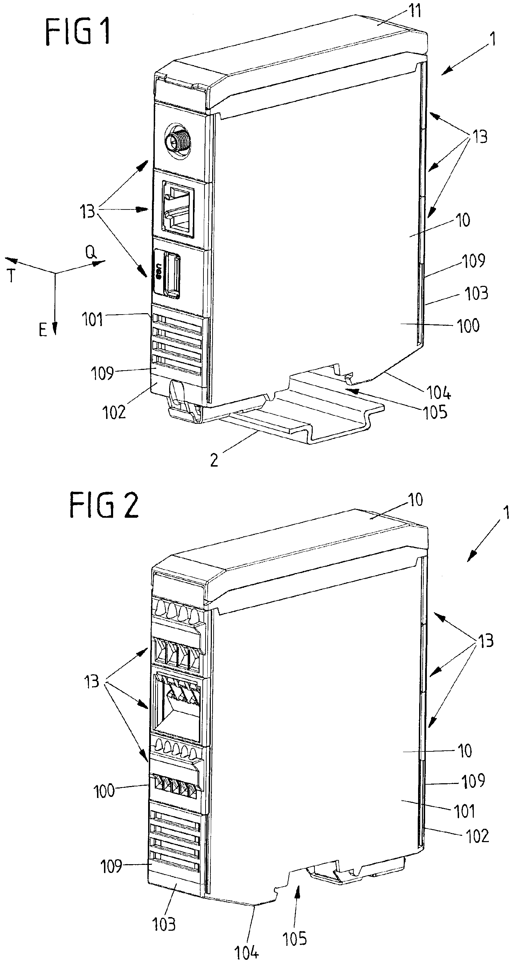

Fig. 1 und 2 zeigen ein Ausführungsbeispiel eines Elektronikgeräts 1, das ein Gehäuse 10 und eine in dem Gehäuse 10 eingefasste elektronische Baugruppe in Form einer Leiterplatte und daran angeordneten Elektronikkomponenten aufweist. Das Elektronikgerät 1 kann über eine Befestigungseinrichtung 105 an einer Unterseite 104 des Gehäuses 10 an eine Tragschiene 2 angesetzt und dabei entlang einer Anreihrichtung T in aneinander angereihter Weise mit anderen Elektronikgeräten 1 kombiniert werden.

Das Gehäuse 10 weist zwei senkrecht zur Anreihrichtung T erstreckte, entlang der Anreihrichtung T zueinander beabstandete Seitenwandungen 100, 101 sowie Stirnseiten 102, 103 auf, die das im wesentlichen quaderförmige Gehäuse 10 definieren. Die Seitenwandungen 100, 101 sind flächig erstreckt derart, dass andere Elektronikgeräte 1 beidseits an das Elektronikgerät 1 angesetzt und mit dem Elektronikgerät 1 an einer Tragschiene 2 kombiniert werden können.

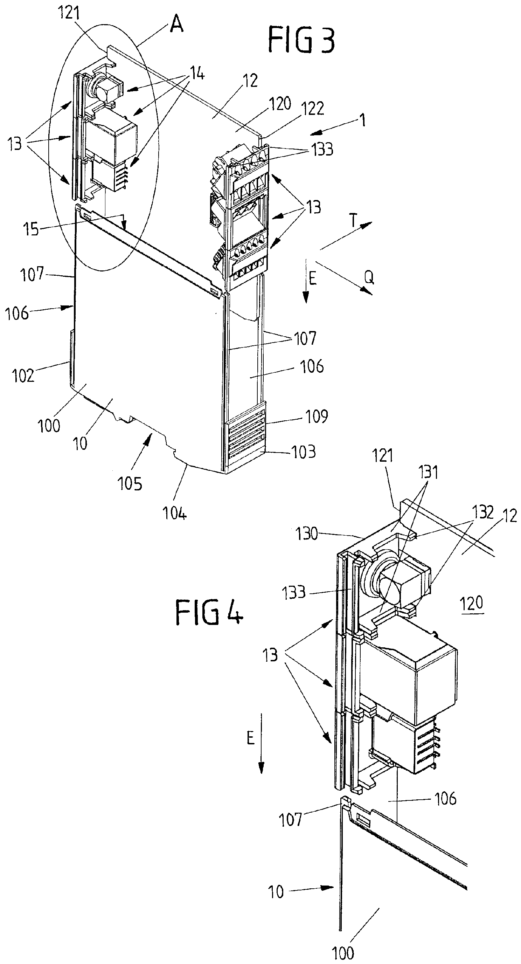

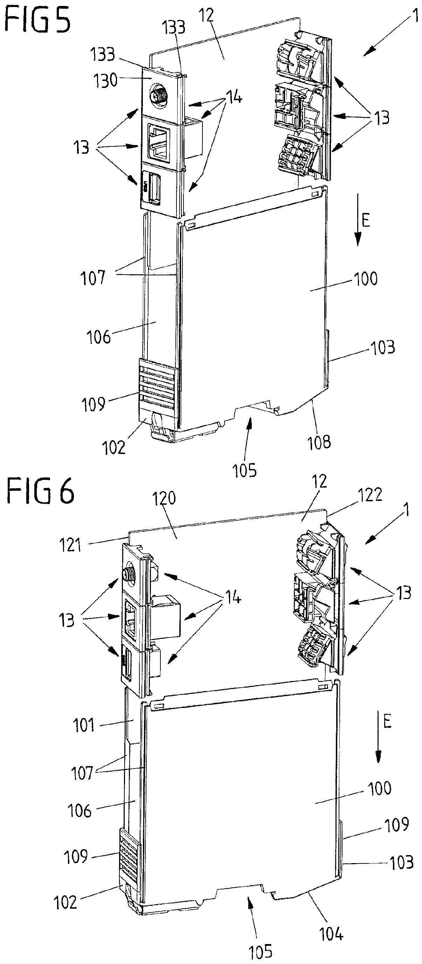

Wie dies aus Fig. 3 bis 8, in denen unterschiedliche Phasen bei der Montage des Elektronikgeräts 1 dargestellt sind, ersichtlich ist, bilden die Seitenwandungen 100, 101 zwischen sich einen Aufnahmeraum 15, in den eine Leiterplatte 12 in eine Einschubrichtung E eingesetzt werden kann derart, dass in einer Montagestellung die Leiterplatte 12 in dem Aufnahmeraum 15 aufgenommen und dabei parallel zu den Seitenwandungen 100, 101 erstreckt ist. An der Leiterplatte 12 können unterschiedliche Elektronikkomponenten, zum Beispiel Elektronikbausteine in Form von elektronischen Schaltkreisen, angeordnet sein, die eine Elektronikbaugruppe des Elektronikgeräts 1 ausbilden.

An die Leiterplatte 12 sind Ansetzteile 13 anzuordnen, die unterschiedliche Funktionen aufweisen können und zusammen mit der Leiterplatte 12 an dem Gehäuse 10 montiert werden. Die Ansetzteile 13 werden an entlang der Einschubrichtung E erstreckten Seitenkanten 121, 122 der Leiterplatte 12 angeordnet und stehen in verbundener Stellung entlang der Anreihrichtung T von einer Oberfläche 120 der Leiterplatte 12 vor.

Das Elektronikgerät 1 kann mittels eines Baukastensystems hergestellt werden, im Rahmen dessen eine Kombination von aus einer Vielzahl von unterschiedlichen Ansetzteilen 13 ausgewählten Ansetzteilen 13 an der Leiterplatte 12 angeordnet und die Leiterplatte 12 mit daran angeordneten Ansetzteilen 13 in das Gehäuse 10 eingesetzt wird, um insbesondere eine gewünschte elektrische Funktionalität für das Elektronikgerät 1 zur Verfügung zu stellen.

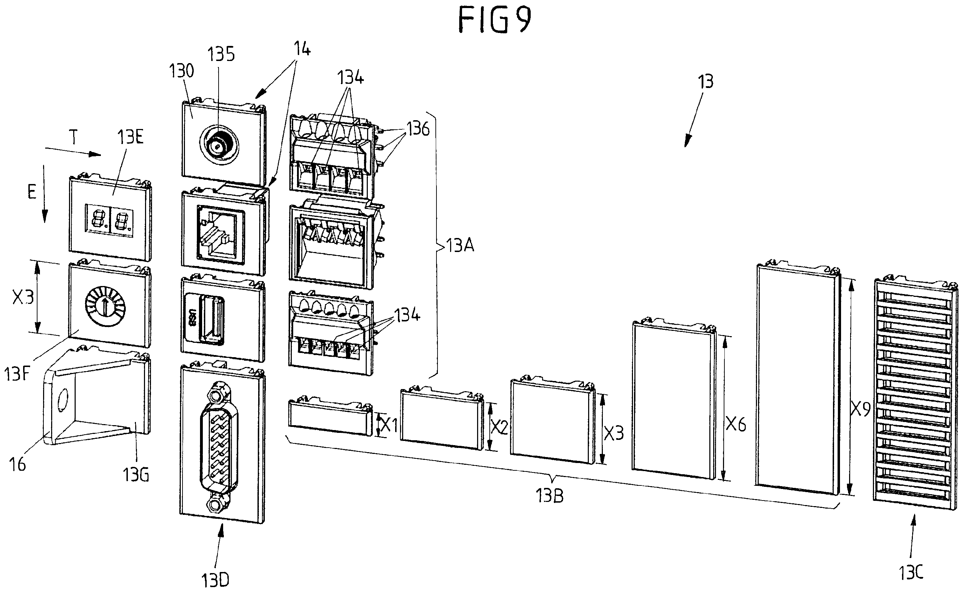

Wie aus Fig. 9 ersichtlich, können ganz unterschiedliche Ansetzteile 13 vorliegen und ein Baukastensystem ausbilden, aus dem ausgewählt werden kann, um die Leiterplatte 12 in variabler Weise zu bestücken und um an dem Elektronikgerät 1 ganz unterschiedliche Funktionalitäten bereitzustellen. Die Ansetzteile 13 weisen hierbei jeweils, betrachtet entlang der Einschubrichtung E, eine Teilung X1, X2, X3, X6, X9 auf, die einer vorbestimmten kleinsten Teilungseinheit X1 oder einem ganzzahligen Vielfachen dieser vorbestimmten kleinsten Teilungseinheit X1 entspricht. Dies ermöglicht, unterschiedliche Ansetzteile 13 in (nahezu) beliebiger Weise miteinander zu kombinieren, um eine gewünschte elektrische und/oder mechanische Funktion an der Leiterplatte 12 und dem Elektronikgerät 1 zur Verfügung zu stellen.

So weisen beispielsweise Ansetzteile 13 in Form von Wandungselementen 13B bei dem Beispiel gemäß Fig. 9 Teilungen X1, X2, X3, X6, X9 auf, die sich voneinander unterscheiden. Ein erstes Wandungselement 13B weist beispielsweise eine Teilung X1 auf, die der vorbestimmten kleinsten Teilungseinheit X1 entspricht. Ein zweites Wandungselement 13B weist demgegenüber eine Teilung X2 auf, die dem Doppelten der kleinsten Teilungseinheit X1 entspricht. Ein anderes Wandungselement 13B weist eine Teilung X3 auf, die dem Dreifachen der kleinsten Teilungseinheit X1 entspricht. Andere Wandungselemente13B weisen eine Teilung X6, X9 auf, die dem Sechsfachen bzw. dem Neunfachen der kleinsten Teilungseinheit X1 entspricht.

Ebenso weisen bei dem Beispiel gemäß Fig. 9 auch die anderen Ansetzteile 13 eine Teilung auf, die der kleinsten Teilungseinheit X1 oder einem ganzzahligen Vielfachen der kleinsten Teilungseinheit X1 entspricht. Die Ansetzteile 13 können in dieser Weise variabel miteinander kombiniert werden, um beispielsweise eine Kombination von Ansetzteilen 13 mit einer vorbestimmten Gesamtlänge zu schaffen, die genau in eine dafür vorgesehene Gehäuseöffnung 106 des Gehäuses 10 passt, wie dies zum Beispiel in Fig. 1 und 2 dargestellt ist.

Wie aus Fig. 3-8 ersichtlich, weist das Gehäuse 10 an jeder Stirnseite 102, 103 je eine Gehäuseöffnung 106 auf, die bei diesem Ausführungsbeispiel eine Länge (gemessen entlang der Einschubrichtung E) des Neunfachen der kleinsten Teilungseinheit X1 aufweist. Entsprechend können in jeder Gehäuseöffnung 106 zum Beispiel gerade drei Ansetzteile 13 mit einer Teilung X3 entsprechend der dreifachen Teilungseinheit X1 angeordnet werden, wie dies zum Beispiel aus Fig. 1 und 2 ersichtlich ist.

Die Ansetzteile 13 bilden beispielsweise Blendenteile für Anschlusseinrichtungen 14 der Leiterplatte 12 (links in Fig. 3) oder Klemmeneinrichtungen zum Anschließen elektrischer Leiter (rechts in Fig. 3) aus und werden vor dem Einsetzen der Leiterplatte 12 in den Aufnahmeraum 15 des Gehäuses 10 mit der Leiterplatte 12 verbunden, sodass eine vormontierte Baueinheit der Leiterplatte 12 mit den daran angeordneten Ansetzteilen 13 geschaffen wird, wie dies zum Beispiel aus Fig. 3 und Fig. 5 und 6 ersichtlich ist. Die so geschaffene vormontierte Baueinheit kann sodann in die Einschubrichtung E an dem Gehäuse 10 montiert werden, indem die Ansetzteile 13 an die Seitenwandungen 100, 101 des Gehäuses 10 angesetzt und in die Einschubrichtung E auf die Seitenwandungen 100, 101 aufgeschoben werden.

Die Ansetzteile 13 weisen jeweils zwei erste Führungseinrichtungen 133 in Form einer Nut auf, die mit Führungsstegen 107 an den seitlichen Kanten der Seitenwandungen 100, 101 in Eingriff gebracht werden können, um die Ansetzteile 13 auf die Seitenwandungen 100, 101 aufzuschieben und so die Leiterplatte 12 in den Aufnahmeraum 15 des Gehäuses 10 einzuführen.

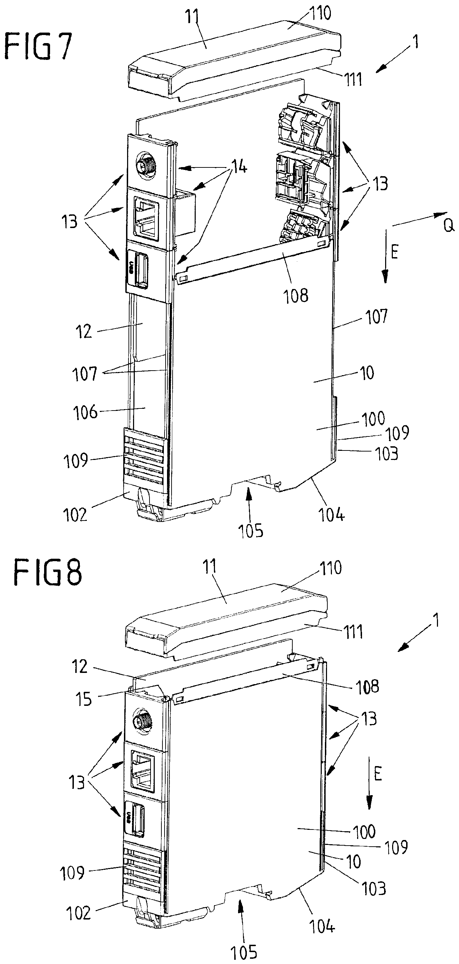

Der Aufnahmeraum 15 ist zwischen den Seitenwandungen 100, 101 gebildet, die entlang der Anreihrichtung T voneinander beabstandet sind und im Bereich der Stirnseiten 102, 103 oberhalb je eines unteren, feststehenden Wandungsabschnitts 109 Gehäuseöffnungen 106 freigeben. Durch Aufschieben der Ansetzteile 13 mit den Nuten der Führungseinrichtungen 133 auf die Führungsstege 107 der Seitenwandungen 100, 101 werden die Ansetzteile 13 - wie dies aus Fig. 7 ersichtlich ist - derart zwischen die Seitenwandungen 100, 101 geschoben, dass die Öffnungen 106 im Bereich der Stirnseiten 102, 103 verschlossen werden und das Gehäuse 10 an seinen Stirnseiten 102, 103 somit durch die unteren, feststehenden Wandungsabschnitte 109 zusammen mit den Ansetzteilen 13 verschlossen ist, wie dies aus Fig. 8 ersichtlich ist.

Nach Einsetzen der aus den Ansetzteilen 13 und der Leiterplatte 12 bestehenden vormontierten Baueinheit wird das Gehäuse 10 durch einen Gehäusedeckel 11 verschlossen, sodass die Leiterplatte 12 nicht aus dem Aufnahmeraum 15 herausfallen kann und somit in dem Aufnahmeraum 15 gesichert ist. Der Gehäusedeckel 11 weist, wie aus Fig. 8 ersichtlich, einen Körper 110 auf, an dem seitliche Stege 111 gebildet sind, die mit Verbindungstegen 108 an den oberen Kanten der Seitenwandungen 100, 101 verrasten, wenn der Gehäusedeckel 11 an das Gehäuse 10 angesetzt wird.

In der Montagestellung ist die Leiterplatte 12 in dem Aufnahmeraum 15 des Gehäuses 10 eingefasst. Die Seitenwandungen 100, 101 sind seitlich über die Ansetzteile 13 miteinander verbunden, sodass der Aufnahmeraum 15 des Gehäuses 10 seitlich über die Ansetzteile 13 abgeschlossen ist.

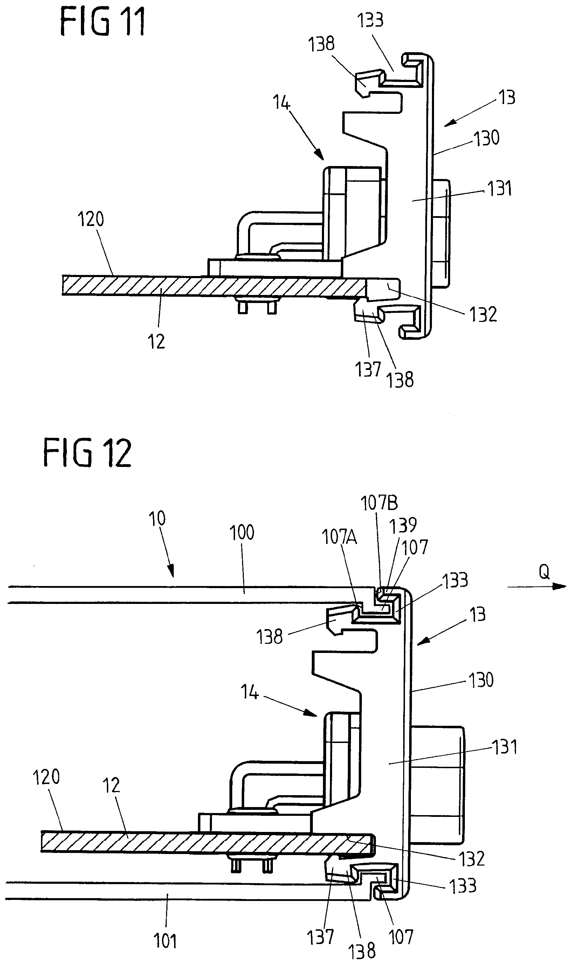

Das Ansetzen der Ansetzteile 13 an die Seitenwandungen 100, 101 des Gehäuses 10 erfolgt in geführter Weise, indem die ersten Führungseinrichtungen 133 der Ansetzteile 13 mit den zweiten Führungseinrichtungen 107 der Seitenwandungen 100, 101 formschlüssig in Eingriff gebracht werden und die Ansetzteile 13 in die Einschubrichtung E in geführter Weise zu den Seitenwandungen 100, 101 verschoben werden. Wie dies zum Beispiel aus der vergrößerten Ansicht gemäß Fig. 4 in Zusammenschau mit Fig. 12 ersichtlich ist, sind die Führungseinrichtungen 133 der Ansetzteile 13 durch Nuten gebildet, die längs entlang der Einschubrichtung E erstreckt sind und einen Eingriff mit einem jeweils zugeordneten Führungssteg 107 an der Seitenkante einer zugeordneten Seitenwandung 100, 101 bereitstellen derart, dass eine in einer Ebene senkrecht zur Einschubrichtung E feste Verbindung zwischen den Ansetzteilen 13 und den Seitenwandungen 101, 101 geschaffen wird, die Ansetzteile 13 entlang der Einschubrichtung E aber zu den Seitenwandungen 100, 101 verschiebbar sind. Eine jede Führungseinrichtung 133 weist hierzu einen rückseitig der Nut geformten, entlang der Einschubrichtung E erstreckten Blockiersteg 138 auf, der den Eingriff eines zugeordneten Führungsstegs 107 in der Nut der Führungseinrichtung 133 sichert derart, dass der Führungssteg 107 nicht entlang der Querrichtung Q außer Eingriff von der Nut der Führungseinrichtung 133 gelangen kann.

Ein jeder Führungssteg 107 bildet zu der zugeordneten Seitenwandung 100, 101 Stufen 107A, 107B aus, die mit dem Blockiersteg 138 sowie mit einem äußeren Begrenzungsabschnitt 139 der Nut der Führungseinrichtung 133 in Anlage sind, sodass darüber der Führungssteg 107 gleitend in der Führungseinrichtung 133 des zugeordneten Ansetzteils 13 gehalten ist und nicht, betrachtet in einer Ebene quer zur Einschubrichtung E, aus der Not heraus gelangen kann, wie dies in Fig. 12 dargestellt ist. Es besteht somit ein formschlüssiger Umgriff für den Führungssteg 107 in der Nut der Führungseinrichtung 133, aufgrund dessen der Führungssteg 107 in der Führungseinrichtung 133 formschlüssig (aber entlang der Einschubrichtung E verschiebbar) gehalten ist.

Diese Ausgestaltung der Führungseinrichtungen 133 und der Führungsstege 107 bewirkt, dass die Ansetzteile 13 in definierter Weise auf die Seitenwandungen 100, 101 aufgeschoben werden können. Dies bewirkt zudem, dass in der Montagestellung eine feste Verbindung zwischen den Ansetzteilen 13 und den Seitenwandungen 100, 101 geschaffen wird, die belastbar ist und ein (ungewolltes) Lösen der Ansetzteile 13 von den Seitenwandungen 100, 101 zuverlässig verhindert.

Wie zum Beispiel aus Fig. 3 und 4 ersichtlich, sind beidseits der Leiterplatte 12 an den Seitenkanten 121, 122 jeweils eine Mehrzahl von entlang der Einschubrichtung E aneinander anschließenden, benachbarten Ansetzteilen 13 angeordnet. Die Ansetzteile 13 weisen jeweils einen Körper 130 auf, der eine quadratische Grundform (betrachtet in einer durch die Einschubrichtung E und die Anreihrichtung T aufgespannten Ebene) aufweist, sodass unterschiedliche Ansetzteile 13 in modularer Weise miteinander kombiniert und an der Leiterplatte 12 angeordnet werden können.

Die Ansetzteile 13 sind Bestandteil eines Baukastensystems und können in einer gewünschten Kombination ausgewählt werden, um ein Elektronikgerät 1 mit bestimmungsgemäßer Funktionalität herzustellen. Die Ansetzteile 13 können hierbei ganz unterschiedliche Funktionen übernehmen können ganz unterschiedlich gestaltet sein, wie dies in einer Übersichtsdarstellung in Fig. 9 dargestellt ist.

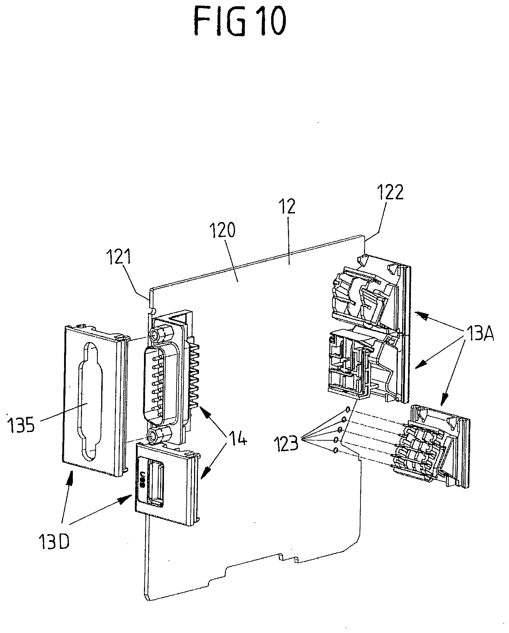

So können Ansetzteile 13 als Klemmeneinrichtungen 13A ausgestaltet sein, die zum Beispiel Stecköffnung 134 aufweisen, in die elektrische Leiter (mit abisolierten Leiterenden) eingesteckt werden können, um die elektrischen Leiter an eine zugeordnete Leiterplatte 12 anzuschließen. Über elektrische Kontaktstifte 136 können die Klemmeneinrichtungen 13A an Kontaktöffnungen 123 der Leiterplatte 12 (siehe Fig. 10) angeordnet werden, um die Klemmeneinrichtungen 13A elektrisch und mechanisch an der Leiterplatte 12 festzulegen. Die Klemmeneinrichtungen 13A können beispielsweise als Federkraftanschlüsse oder dergleichen verwirklicht sein und ein (einfaches) Anschließen elektrischer Leiter ermöglichen.

Unterschiedliche Klemmeneinrichtungen 13A können unterschiedlich dimensionierte Stecköffnungen 134 zur Aufnahme von Leitern unterschiedlichen Leitungsquerschnitts aufweisen, wie dies aus Fig. 9 ersichtlich ist. So weisen die in Fig. 9 oben dargestellte Klemmeneinrichtung 13A und die in Fig. 9 unten dargestellte Klemmeneinrichtung 13A unterschiedlich dimensionierte Stecköffnungen 134 zum Einstecken von Leitern mit unterschiedlichem Leiterquerschnitt auf.

In alternativer Ausgestaltung können Ansetzteile 13 auch als Wandungselemente 13B ausgestaltet sein, die einen flächigen Abschluss für das Gehäuse 10 bereitstellen und unterschiedliche Größen aufweisen können.

In wiederum alternativer Ausgestaltung können Ansetzteile 13 Gitterelemente 13C bereitstellen, über die beispielsweise eine Kühlung für eine in dem Gehäuse 10 eingefasste Elektronikbaugruppe bereitgestellt werden kann.

In wiederum anderer Ausgestaltung können die Ansetzteile 13 Blendenteile 130 verwirklichen, die an elektrische Anschlusseinrichtungen 14, zum Beispiel Steckverbinder zum Bereitstellen eines koaxialen Anschlusses, eines Netzwerkanschlusses, eines USB-Anschlusses oder einer parallelen oder seriellen Schnittstelle, angesetzt werden können. Die Blendenteile 130 weisen Öffnungen 135 auf, über die ein Anschließen von Steckverbindern an die Anschlusseinrichtungen 14 möglich ist.

Denkbar möglich sind auch andere Ausgestaltungen von Ansetzteilen 13. Beispielsweise können die Ansetzteile 13 Bedienelemente 13F (zum Beispiel Schalter), Anzeigen 13E (LEDs, Displays) oder auch mechanische Funktionskomponenten 13G zum Beispiel mit einem außen abstehenden Schraubflansch 16 zur Fixierung des Gehäuses 10 an einer externen Baueinheit oder dergleichen bereitstellen.

Die Ansetzteile 13 sind an der Leiterplatte 12 anzuordnen, um auf diese Weise eine vormontierte Baueinheit zu schaffen, die an dem Gehäuse 10 zum Komplettieren des Elektronikgeräts 1 montiert werden kann. Das Verbinden der Ansetzteile 13 mit der Leiterplatte 12 kann in einer Ausgestaltung beispielsweise dadurch erfolgen, dass Kontaktstifte 136 in zugeordnete Kontaktöffnungen 123 (siehe Fig. 9 und 10 an den Klemmeneinrichtungen 13A) eingesetzt und mit der Leiterplatte 12 z.B. verlötet werden, sodass eine elektrische und mechanische Verbindung mit der Leiterplatte 12 geschaffen wird. Denkbar und möglich ist in einer Ausgestaltung aber auch, dass die Ansetzteile 13 in anderer Weise, zum Beispiel kraftschlüssig oder formschlüssig, mit der Leiterplatte 12 verbunden werden.

So können die Ansetzteile 13 beispielsweise, wie dies aus Fig. 3 und 4 in Zusammenschau mit Fig. 11 bis 15 ersichtlich ist, Eingriffsaufnahmen 132 an Stegen 131 aufweisen, mit denen ein jedes Ansetzteil 13 auf eine zugeordnete Seitenkante 121, 122 der Leiterplatte 12 aufgesteckt werden kann, wie dies zum Beispiel aus dem Übergang von Fig. 11 hin zu Fig. 12 ersichtlich ist. An dem Ansetzteil 13 kann hierbei eine Fixiernase 137 geformt sein, die beim Ansetzen eine kraftschlüssige oder formschlüssige Verbindung bewirkt.

Bei dem Ausführungsbeispiel gemäß Fig. 11 und 12 beispielsweise wird die zugeordnete Seitenkante 121, 122 der Leiterplatte 12 klemmend in den Eingriffsaufnahmen 132 aufgenommen dadurch, dass die Fixiernasen 137 der Eingriffsaufnahmen 132 (unter geringfügiger Deformation) pressend gegen die Leiterplatte 12 drücken und somit einen Kraftschluss herstellen.

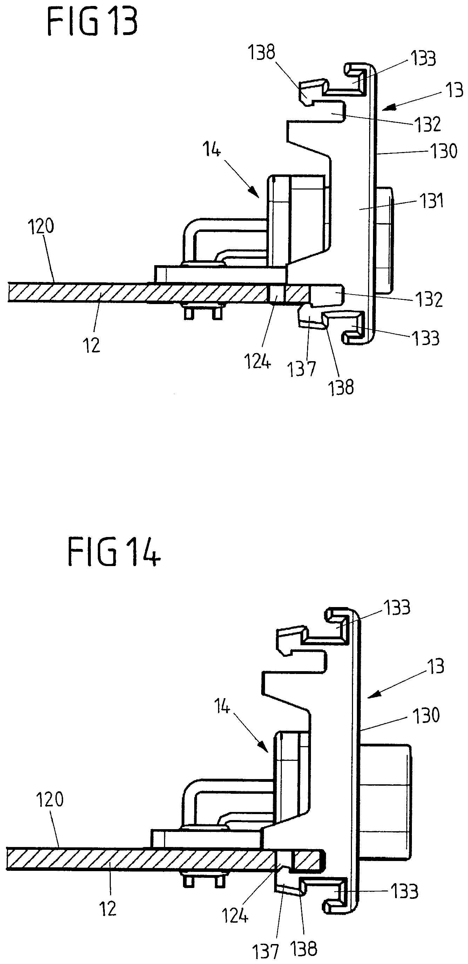

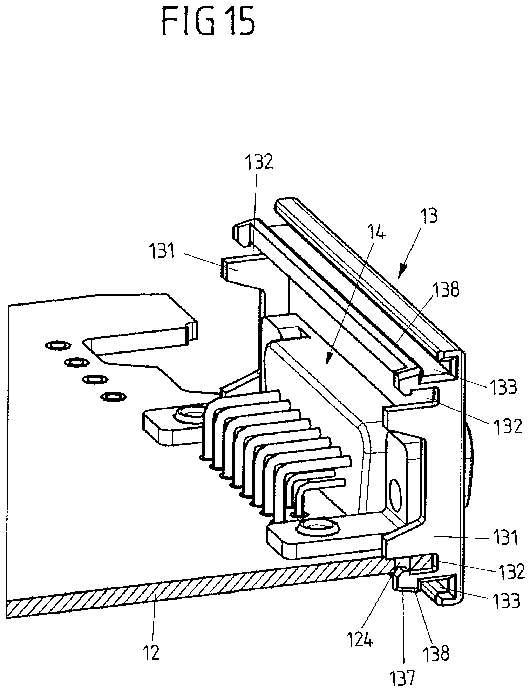

Bei dem Ausführungsbeispiel gemäß Fig. 13 bis 15 hingegen greifen die Fixiernasen 137 nach Ansetzen des jeweiligen Ansetzteils 13 an die Leiterplatte 12 in zugeordnete Rastöffnungen 124 der Leiterplatte 12 ein, sodass ein Formschluss hergestellt wird, aufgrund dessen das Ansetzteil 13 an der Leiterplatte 12 gehalten ist. Eine jede Fixiernase 137 schnappt bei Ansetzen des Ansetzteils 13 an die zugeordnete Seitenkante 121, 122 der Leiterplatte 12 in Eingriff mit einer zugeordneten Rastöffnung 124 der Leiterplatte 12, sodass in angesetzter Stellung eine rastende, formschlüssige Verbindung zwischen dem Ansetzteil 13 und der Leiterplatte 12 geschaffen ist, wie dies aus dem Übergang von Fig. 13 hin zu Fig. 14 und zudem in Fig. 15 ersichtlich ist.

Das jeweilige Ansetzteil 13 kann somit in einfacher Weise an der Leiterplatte 12 angeordnet werden und ist in angesetzter Stellung kraftschlüssig oder formschlüssig mit der Leiterplatte 12 verbunden.

Der der Erfindung zugrunde liegende Gedanke ist nicht auf die vorangehenden Ausführungsbeispiele beschränkt, sondern lässt sich auch in gänzlich andersgearteter Weise verwirklichen.

Ein Elektronikgerät der hier beschriebenen Art kann ganz unterschiedliche Funktionen zum Beispiel zum Steuern von elektrischen Maschinen, zum Auswerten von Sensorsignalen, zum Bereitstellen einer Stromversorgung oder dergleichen übernehmen. Ein Elektronikgerät der hier beschriebenen Art kann hierbei mit anderen elektrischen oder elektronischen Baugruppen an einer Tragschiene kombiniert werden, sodass eine komplexe elektrische Anlage zum Beispiel in einem Schaltschrank geschaffen werden kann.

**Bezugszeichenliste**

| | |
|---|---|
| 1 | Elektronikgerät |
| 10 | Gehäuse |
| 100, 101 | Seitenwandung |
| 102, 103 | Stirnseite |
| 104 | Unterseite |
| 105 | Befestigungseinrichtung |
| 106 | Öffnung |
| 107 | Führungskante |
| 108 | Verbindungssteg |
| 109 | Wandungsabschnitt |
| 11 | Gehäusedeckel |
| 110 | Körper |
| 111 | Steg |
| 12 | Leiterplatte |
| 120 | Oberfläche |
| 121, 122 | Seitenkante |
| 123 | Kontaktöffnungen |
| 124 | Rastöffnung |
| 13, 13A-13G | Ansetzteil |
| 130 | Körper |
| 131 | Steg |
| 132 | Eingriffsaufnahme |
| 133 | Führungseinrichtung |
| 134 | Stecköffnung |
| 135 | Öffnung |
| 136 | Kontaktstifte |
| 137 | Fixiernase |
| 138 | Blockiersteg |
| 139 | Begrenzungssteg |
| 14 | Anschlusseinrichtung |
| 15 | Aufnahmeraum |
| 16 | Schraubflansch |
| 2 | Tragschiene |
| E | Einschubrichtung |
| Q | Querrichtung |
| T | Anreihrichtung |
| X1, X2, X3, X6, X9 | Teilung |

## Patentansprüche

1. Baukastensystem zum Herstellen eines Elektronikgeräts (1), mit einem Gehäuse (10), das einen Aufnahmeraum (15) ausbildet, und einer Leiterplatte (12), die entlang einer Einschubrichtung (E) in den Aufnahmeraum (15) des Gehäuses (10) einsetzbar und in einer Montagestellung in dem Aufnahmeraum (15) aufgenommen ist, **gekennzeichnet durch** eine Mehrzahl von mit der Leiterplatte (12) verbindbaren Ansetzteilen (13, 13A-13G), die jeweils, betrachtet entlang der Einschubrichtung (E), eine Teilung (X1, X2, X3, X6, X9) aufweisen, die einer vorbestimmten kleinsten Teilungseinheit (X1) oder einem ganzzahligen Vielfachen der vorbestimmten kleinsten Teilungseinheit (X1) entspricht, wobei jedes Ansetzteil (13, 13A-13G) eine erste Führungseinrichtung (133) zur Führung an einer zweiten Führungseinrichtung (107) des Gehäuses (10) aufweist und eine Kombination unterschiedlicher Ansetzteile (13, 13A-13G) entlang der Einschubrichtung (E) aneinander angereiht mit der Leiterplatte (12) derart verbindbar ist, dass bei Einsetzen der Leiterplatte (12) in den Aufnahmeraum (15) die Kombination von Ansetzteilen (13, 13A-13G) über die ersten Führungseinrichtungen (133) an der zweiten Führungseinrichtung (107) des Gehäuses (10) entlang der Einschubrichtung (E) verschiebbar geführt ist
wobei die Ansetzteile (13, 13A-13G)
• Blendenteile für einen mit der Leiterplatte (12) elektrisch verbundenen elektrischen Anschluss (14),
• Klemmeneinrichtungen mit zumindest einer Stecköffnung (134) zum Anschließen eines elektrischen Leiters,
• geschlossene, flächige Wandungselemente zum Verschließen des Gehäuses (10), Gitterelemente
• oder mechanische und/oder elektrische Funktionselemente ausbilden.

2. Baukastensystem nach Anspruch 1, **dadurch gekennzeichnet, dass** das Gehäuse (10) zwei entlang einer Anreihrichtung (T) zueinander beabstandete, zwischen sich einen Aufnahmeraum (15) ausbildende Seitenwandungen (100, 101) aufweist, wobei die Einschubrichtung (E) quer zur Anreihrichtung (T) gerichtet ist und die Leiterplatte (12) in der Montagestellung in einer senkrecht zur Anreihrichtung (T) erstreckten Stellung in dem Aufnahmeraum (15) aufgenommen ist.

3. Baukastensystem nach Anspruch 2, **dadurch gekennzeichnet, dass** die Ansetzteile (13, 13A-13G) in der Montagestellung die Seitenwandungen (100, 101) formschlüssig miteinander verbinden.

4. Baukastensystem nach Anspruch 2 oder 3, **dadurch gekennzeichnet, dass** jedes Ansetzteil (13, 13A-13G) zwei erste Führungseinrichtungen (133) und jede Seitenwandung (100, 101) eine zweite Führungseinrichtung (107) aufweist.

5. Baukastensystem nach Anspruch 4, **dadurch gekennzeichnet, dass** zur Montage des Gehäuses (10) die ersten Führungseinrichtungen (133) und die zweiten Führungseinrichtungen (107) derart miteinander in Eingriff bringbar sind, dass die Kombination von Ansetzteilen (13, 13A-13G) in einer senkrecht zur Einschubrichtung (E) erstreckten Ebene fest mit den Seitenwandungen (100, 101) verbunden ist, entlang der Einschubrichtung (E) aber zu den Seitenwandungen (100, 101) verschiebbar ist.

6. Baukastensystem nach Anspruch 4 oder 5, **dadurch gekennzeichnet, dass** jede erste Führungseinrichtung (133) mit einer zugeordneten zweiten Führungseinrichtung (107) formschlüssig durch Eingriff eines Stegs (107) in eine Nut in Eingriff bringbar ist.

7. Baukastensystem nach einem der Ansprüche 4 bis 6, **dadurch gekennzeichnet, dass** die zweiten Führungseinrichtungen (107) jeweils einen Steg (107) und die ersten Führungseinrichtungen (133) jeweils eine mit dem Steg einer zugeordneten zweiten Führungseinrichtung (133) in Eingriff bringbare Nut aufweisen.

8. Baukastensystem nach Anspruch 6 oder 7, **dadurch gekennzeichnet, dass** die ersten Führungseinrichtungen (133) je einen Blockiersteg (138) aufweisen, der die Nut entlang einer senkrecht zur Einschubrichtung (E) und senkrecht zur Anreihrichtung (T) erstreckten Querrichtung (Q) begrenzt derart, dass der zugeordnete Steg entlang der Querrichtung (Q) in Eingriff mit der Nut gehalten wird.

9. Baukastensystem nach einem der Ansprüche 2 bis 8, **dadurch gekennzeichnet, dass** die Ansetzteile (13, 13A-13G) der Kombination von Ansetzteilen (13, 13A-13G) in der Montagestellung entlang der Anreihrichtung (T) zwischen den Seitenwandungen (100, 101) erstreckt sind.

10. Baukastensystem nach einem der vorangehenden Ansprüche, **dadurch gekennzeichnet, dass** die Kombination von Ansetzteilen (13, 13A-13G) in der Montagestellung eine Begrenzung für den Aufnahmeraum (15) nach außen hin bildet.

11. Baukastensystem nach einem der vorangehenden Ansprüche, **dadurch gekennzeichnet, dass** jedes Ansetzteil (13, 13A-13G) einen Körper (130) aufweist, der, betrachtet entlang der Einschubrichtung (E), die Teilung (X1, X2, X3, X6, X9) definiert.

12. Baukastensystem nach einem der vorangehenden Ansprüche, **dadurch gekennzeichnet, dass** die Leiterplatte (12) entlang der Einschubrichtung (E) erstreckte, gegenüberliegende Seitenkanten (121, 122) aufweist, wobei die Kombination von Ansetzteilen (13, 13A-13G) an einer der Seitenkanten (121, 122) mit der Leiterplatte (12) verbindbar ist.

13. Baukastensystem nach einem der vorangehenden Ansprüche, **dadurch gekennzeichnet, dass** die Leiterplatte (12) in der Montagestellung über die Kombination von Ansetzteilen (13, 13A-13G) in dem Aufnahmeraum (15) des Gehäuses (10) fixiert ist.

14. Baukastensystem nach einem der vorangehenden Ansprüche, **dadurch gekennzeichnet, dass** die Kombination von Ansetzteilen (13, 13A-13G) stoffschlüssig, kraftschlüssig oder formschlüssig mit der Leiterpatte (12) verbindbar ist.

15. Baukastensystem nach einem der vorangehenden Ansprüche, **gekennzeichnet durch** eine Befestigungseinrichtung (105) zum Verbinden des Elektronikgeräts (1) mit einer Tragschiene (2).

16. Verfahren zum Herstellen eines Elektronikgeräts (1) unter Verwendung eines Baukastensystems, bei dem eine Leiterplatte (12) entlang einer Einschubrichtung (E) in einen Aufnahmeraum (15) eines Gehäuses (10) eingesetzt wird und in einer Montagestellung in dem Aufnahmeraum (15) aufgenommen ist, **dadurch gekennzeichnet, dass** eine Kombination unterschiedlicher Ansetzteile (13, 13A-13G), die jeweils, betrachtet entlang der Einschubrichtung (E), eine Teilung (X1, X2, X3, X6, X9) aufweisen, die einer vorbestimmten kleinsten Teilungseinheit (X1) oder einem ganzzahligen Vielfachen der vorbestimmten kleinsten Teilungseinheit (X1) entspricht, entlang der Einschubrichtung (E) aneinander angereiht mit der Leiterplatte (12) verbunden wird und die Leiterplatte (12) in den Aufnahmeraum (15) des Gehäuses (10) derart eingesetzt wird, dass erste Führungseinrichtungen (133) der Kombination von Ansetzteilen (13, 13A-13G) an einer zweiten Führungseinrichtung (107) des Gehäuses (10) der Einschubrichtung (E) verschiebbar geführt werden,
wobei die Ansetzteile (13, 13A-13G)
• Blendenteile für einen mit der Leiterplatte (12) elektrisch verbundenen elektrischen Anschluss (14),
• Klemmeneinrichtungen mit zumindest einer Stecköffnung (134) zum Anschließen eines elektrischen Leiters,
• geschlossene, flächige Wandungselemente zum Verschließen des Gehäuses (10), Gitterelemente
• oder mechanische und/oder elektrische Funktionselemente ausbilden.

## Claims

1. Modular system for producing an electronic device (1), having a housing (10), which configures a receiving space (15), and having a printed circuit board (12) which can be inserted into the receiving space (15) of the housing (10) along an insertion direction (E) and which is received in the receiving space (15) in an assembly position, **characterized by** a plurality of attachment parts (13, 13A-13G) which can be connected to the printed circuit board (12) and which in each case have, as viewed along the insertion direction (E), a pitch (X1, X2, X3, X6, X9) which corresponds to a predetermined smallest pitch unit (X1) or to an integer multiple of the predetermined smallest pitch unit (X1), wherein each attachment part (13, 13A-13G) has a first guide apparatus (133) for guidance on a second guide apparatus (107) of the housing (10), and a combination of different attachment parts (13, 13A-13G), lined up against one another along the insertion direction (E), can be connected to the printed circuit board (12) in such a way that, when the printed circuit board (12) is inserted into the receiving space (15), the combination of attachment parts (13, 13A-13G) is guided, by way of the first guide apparatuses (133), on the second guide apparatus (107) of the housing (10) in a displaceable manner along the insertion direction (E),
wherein the attachment parts (13, 13A-13G) configure
• screen parts for an electrical connection (14) which is electrically connected to the printed circuit board (12),
• terminal apparatuses having at least one plug-in opening (134) for connection of an electrical conductor,
• closed, areal wall elements for closing the housing (10), grid elements
• or mechanical and/or electrical functional elements.

2. Modular system according to Claim 1, **characterized in that** the housing (10) has two side walls (100, 101) which are spaced apart from one another along a lining-up direction (T) and which between them configure a receiving space (15), wherein the insertion direction (E) is directed transversely with respect to the lining-up direction (T) and, in the assembly position, the printed circuit board (12) is received in the receiving space (15) in a position extending perpendicularly with respect to the lining-up direction (T).

3. Modular system according to Claim 2, **characterized in that**, in the assembly position, the attachment parts (13, 13A-13G) connect the side walls (100, 101) to one another in a positively locking manner.

4. Modular system according to Claim 2 or 3, **characterized in that** each attachment part (13, 13A-13G) has two first guide apparatuses (133), and each side wall (100, 101) has a second guide apparatus (107) .

5. Modular system according to Claim 4, **characterized in that**, in order to assemble the housing (10), the first guide apparatuses (133) and the second guide apparatuses (107) are brought into engagement with one another in such a way that the combination of attachment parts (13, 13A-13G) is fixedly connected to the side walls (100, 101) along a plane extending perpendicularly with respect to the insertion direction (E) but can be displaced relative to the side walls (100, 101) along the insertion direction (E) .

6. Modular system according to Claim 4 or 5, **characterized in that** each first guide apparatus (133) can be brought into engagement with an associated second guide apparatus (107) in a positively locking manner as a result of engagement of a web (107) into a groove.

7. Modular system according to one of Claims 4 to 6, **characterized in that** each of the second guide apparatuses (107) has a web (107) and each of the first guide apparatuses (133) has a groove which can be brought into engagement with the web of an associated second guide apparatus (133).

8. Modular system according to Claim 6 or 7, **characterized in that** the first guide apparatuses (133) have a respective blocking web (138) which delimits the groove along a transverse direction (Q), extending perpendicularly with respect to the insertion direction (E) and perpendicularly with respect to the lining-up direction (T), in such a way that the associated web is held in engagement with the groove along the transverse direction (Q).

9. Modular system according to one of Claims 2 to 8, **characterized in that**, in the assembly position, the attachment parts (13, 13A-13G) of the combination of attachment parts (13, 13A-13G) extend along the lining-up direction (T) between the side walls (100, 101) .

10. Modular system according to one of the preceding claims, **characterized in that**, in the assembly position, the combination of attachment parts (13, 13A-13G) forms a delimitation for the receiving space (15) towards the outside.

11. Modular system according to one of the preceding claims, **characterized in that** each attachment part (13, 13A-13G) has a body (130) which defines, as viewed along the insertion direction (E), the pitch (X1, X2, X3, X6, X9) .

12. Modular system according to one of the preceding claims, **characterized in that** the printed circuit board (12) has opposite side edges (121, 122) which extend along the insertion direction (E), wherein the combination of attachment parts (13, 13A-13G) can be connected to the printed circuit board (12) at one of the side edges (121, 122).

13. Modular system according to one of the preceding claims, **characterized in that**, in the assembly position, the printed circuit board (12) is fixed in the receiving space (15) of the housing (10) by way of the combination of attachment parts (13, 13A-13G) .

14. Modular system according to one of the preceding claims, **characterized in that** the combination of attachment parts (13, 13A-13G) can be connected to the printed circuit board (12) in a materially bonded, force-fitting or positively locking manner.

15. Modular system according to one of the preceding claims, **characterized by** a fastening apparatus (105) for connecting the electronic device (1) to a carrier rail (2).

16. Method for producing an electronic device (1) using a modular system, in which a printed circuit board (12) is inserted into a receiving space (15) of a housing (10) along an insertion direction (E) and is received in the receiving space (15) in an assembly position, **characterized in that** a combination of different attachment parts (13, 13A-13G), which each have, as viewed along the insertion direction (E), a pitch (X1, X2, X3, X6, X9) which corresponds to a predetermined smallest pitch unit (X1) or to an integer multiple of the predetermined smallest pitch unit (X1), is connected to the printed circuit board (12) so as to be lined up against one another along the insertion direction (E), and the printed circuit board (12) is inserted into the receiving space (15) of the housing (10) in such a way that first guide apparatuses (133) of the combination of attachment parts (13, 13A-13G) are guided on a second guide apparatus (107) of the housing (10) in a displaceable manner the insertion direction (E),
wherein the attachment parts (13, 13A-13G) configure
• screen parts for an electrical connection (14) which is electrically connected to the printed circuit board (12),
• terminal apparatuses having at least one plug-in opening (134) for connection of an electrical conductor,
• closed, areal wall elements for closing the housing (10), grid elements
• or mechanical and/or electrical functional elements.

## Revendications

1. Système modulaire destiné à la fabrication d'un appareil électronique (1), ledit système comprenant un boîtier (10), qui forme un espace de réception (15), et une carte de circuit imprimé (12) qui peut être insérée dans l'espace de réception (15) du boîtier (10) suivant une direction d'insertion (E) et qui est reçue dans une position de montage dans l'espace de réception (15), **caractérisé par** une pluralité de pièces de fixation (13, 13A-13G) qui peuvent être reliées à la carte de circuit imprimé (12) et qui, dans une vue suivant la direction d'insertion (E), comportent chacun un pas (X1, X2, X3, X6, X9) qui correspond à une plus petite unité de pas prédéterminée (X1) ou à un multiple entier de la plus petite unité de pas prédéterminée (X1), chaque pièce de fixation (13, 13A-13G) comportant un premier dispositif de guidage (133) destiné à effectuer un guidage sur un deuxième dispositif de guidage (107) du boîtier (10) et une combinaison de différentes pièces de fixation (13, 13A-13G) pouvant être reliées suivant la direction d'insertion (E) à la carte de circuit imprimé (12) en étant jointes les unes sur les autres de manière à ce que, lorsque la carte de circuit imprimé (12) est insérée dans l'espace de réception (15), la combinaison de pièces de fixation (13, 13A-13G) soit guidée de manière coulissante par le biais des premiers dispositifs de guidage (133) sur le deuxième dispositif de guidage (107) du boîtier (10) suivant la direction d'insertion (E),
les pièces de fixation (13, 13A-13G) formant
• des pièces de masquage destinées à une borne électrique (14) reliée électriquement à la carte de circuit imprimé (12),
• des dispositifs de serrage comprenant au moins une ouverture d'enfichage (134) destinée au raccordement d'un conducteur électrique,
• des éléments de paroi sensiblement bidimensionnels et fermés destinés à fermer le boîtier (10), des éléments en treillis
• ou des éléments fonctionnels mécaniques et/ou électriques.

2. Système modulaire selon la revendication 1, **caractérisé en ce que** le boîtier (10) comporte deux parois latérales (100, 101) qui sont espacées l'une de l'autre suivant une direction de jonction (T) et qui forment entre elles un espace de réception (15), la direction d'insertion (E) étant orientée transversalement à la direction de jonction (T) et la carte de circuit imprimé (12) étant reçue dans l'espace de réception (15) dans une position étendue perpendiculairement à la direction de jonction (T) dans la position de montage.

3. Système modulaire selon la revendication 2, **caractérisé en ce que** les pièces de fixation (13, 13A-13G) relient les parois latérales (100, 101) entre elles par complémentarité de formes dans la position de montage.

4. Système modulaire selon la revendication 2 ou 3, **caractérisé en ce que** chaque pièce de fixation (13, 13A-13G) comporte deux premiers dispositifs de guidage (133) et chaque paroi latérale (100, 101) comporte un deuxième dispositif de guidage (107).

5. Système modulaire selon la revendication 4, **caractérisé en ce que**, pour effectuer le montage du boîtier (10), les premiers dispositifs de guidage (133) et les deuxièmes dispositifs de guidage (107) peuvent être amenés en engagement les uns avec les autres de manière à ce que la combinaison de pièces de fixation (13, 13A-13G) soit reliée solidairement aux parois latérales (100, 101) dans un plan s'étendant perpendiculairement à la direction d'insertion (E), mais puisse être déplacée par rapport aux parois latérales (100, 101) suivant la direction d'insertion (E) .

6. Système modulaire selon la revendication 4 ou 5, **caractérisé en ce que** chaque premier dispositif de guidage (133) peut être amené en engagement par complémentarité de formes avec un deuxième dispositif de guidage associé (107) par engagement d'une nervure (107) dans une rainure.

7. Système modulaire selon l'une des revendications 4 à 6, **caractérisé en ce que** les deuxièmes dispositifs de guidage (107) comportent chacun une nervure (107) et les premiers dispositifs de guidage (133) comportent chacun une rainure qui peut être amenée en engagement avec la nervure d'un deuxième dispositif de guidage associé (133).

8. Système modulaire selon la revendication 6 ou 7, **caractérisé en ce que** les premiers dispositifs de guidage (133) comportent chacun une nervure de blocage (138) qui délimite la rainure suivant une direction transversale (Q) perpendiculaire à la direction d'insertion (E) et perpendiculaire à la direction de jonction (T) de manière à ce que la nervure associée soit maintenue en engagement avec la rainure suivant la direction transversale (Q).

9. Système modulaire selon l'une des revendications 2 à 8, **caractérisé en ce que** les pièces de fixation (13, 13A-13G) de la combinaison de pièces de fixation (13, 13A-13G) s'étendent entre les parois latérales (100, 101) suivant la direction de jonction (T) dans la position de montage.

10. Système modulaire selon l'une des revendications précédentes, **caractérisé en ce que** la combinaison des pièces de fixation (13, 13A-13G) forme dans la position de montage une délimitation de l'espace de réception (15) par rapport à l'extérieur.

11. Système modulaire selon l'une des revendications précédentes, **caractérisé en ce que** chaque pièce de fixation (13, 13A-13G) comporte un corps (130) qui, dans une vue suivant la direction d'insertion (E), définit le pas (X1, X2, X3, X6, X9).

12. Système modulaire selon l'une des revendications précédentes, **caractérisé en ce que** la carte de circuit imprimé (12) comporte des bords latéraux opposés (121, 122) qui s'étendent suivant la direction d'insertion (E), la combinaison de pièces de fixation (13, 13A-13G) pouvant être reliée à la carte de circuit imprimé (12) au niveau de l'un des bords latéraux (121, 122).

13. Système modulaire selon l'une des revendications précédentes, **caractérisé en ce que** la carte de circuit imprimé (12) est fixée dans l'espace de réception (15) du boîtier (10) par le biais de la combinaison de pièces de fixation (13, 13A-13G) dans la position de montage.

14. Système modulaire selon l'une des revendications précédentes, **caractérisé en ce que** la combinaison de pièces de fixation (13, 13A-13G) peut être reliée à la carte de circuit imprimé (12) par une liaison de matière, en force ou par complémentarité de formes.

15. Système modulaire selon l'une des revendications précédentes, **caractérisé par** un dispositif de fixation (105) destiné à relier l'appareil électronique (1) à un rail de support (2).

16. Procédé de fabrication d'un appareil électronique (1) à l'aide d'un système modulaire, procédé dans lequel une carte électronique (12) est insérée suivant une direction d'insertion (E) dans un espace de réception (15) d'un boîtier (10) et est reçue dans l'espace de réception (15) dans une position de montage, **caractérisé en ce qu'**une combinaison de différentes pièces de fixation (13, 13A-13G), qui comporte à chaque fois dans une vue suivant la direction d'insertion (E) un pas (X1, X2, X3, X6, X9) qui correspond à une unité de pas la plus petite prédéterminée (X1) ou un multiple entier de l'unité de pas la plus petite prédéterminée (X1), est reliée à la carte de circuit imprimé (12) suivant la direction d'insertion (E) en étant jointes les unes aux autres et la carte de circuit imprimé (12) est insérée dans l'espace de réception (15) du boîtier (10) de manière à ce que des premiers dispositifs de guidage (133) de la combinaison de pièces de fixation (13, 13A-13G) soient guidés par coulissement la direction d'insertion (E) sur un deuxième dispositif de guidage (107) du boîtier (10),
les pièces de fixation (13, 13A-13G) formant
• des pièces de masquage destinées à une borne électrique (14) reliée électriquement à la carte de circuit imprimé (12),
• des dispositifs de serrage comprenant au moins une ouverture d'enfichage (134) destinée au raccordement d'un conducteur électrique,
• des éléments de paroi sensiblement bidimensionnels et fermés destinés à fermer le boîtier (10), des éléments en treillis
• ou des éléments fonctionnels mécaniques et/ou électriques.
